(19) **Europäisches Patentamt**

**European Patent Office**

**Office européen des brevets**

(11) **EP 1 114 326 B1**

(12) **EUROPÄISCHE PATENTSCHRIFT**

(45) Veröffentlichungstag und Bekanntmachung des Hinweises auf die Patenterteilung:
**12.04.2006 Patentblatt 2006/15**

(51) Int Cl.:
***G01R 21/133*** *(2006.01)*

(21) Anmeldenummer: **99969150.4**

(22) Anmeldetag: **13.09.1999**

(86) Internationale Anmeldenummer:
**PCT/EP1999/006771**

(87) Internationale Veröffentlichungsnummer:
**WO 2000/016109 (23.03.2000 Gazette 2000/12)**

(54) **ELEKTRIZITÄTSZÄHLER UND EINGANGSBAUSTEIN FÜR EINEN ELEKTRIZITÄTSZÄHLER**

ELECTRICITY METER AND AN INPUT MODULE FOR AN ELECTRICITY METER

COMPTEUR ELECTRIQUE ET MODULE D'ENTREE POUR COMPTEUR ELECTRIQUE

(84) Benannte Vertragsstaaten:
**CH DE FR GB LI SE**

(30) Priorität: **15.09.1998 DE 19842241**

(43) Veröffentlichungstag der Anmeldung:
**11.07.2001 Patentblatt 2001/28**

(73) Patentinhaber: **Landis+Gyr AG**
**6300 Zug (CH)**

(72) Erfinder:
• **DE VRIES, Jacob**
**CH-6319 Allenwinden (CH)**

• **SCHALLER, Michel**
**CH-6340 Baar (CH)**
• **JEKER, Erich**
**CH-6340 Baar (CH)**

(74) Vertreter: **Lagler, Louis**
**Rentsch & Partner**
**Postfach 2441**
**8022 Zürich (CH)**

(56) Entgegenhaltungen:
**EP-A- 0 887 650        CH-A- 683 579**
**CH-A- 687 423        GB-A- 2 167 619**
**US-A- 5 349 676**

## Beschreibung

Die Erfindung betrifft einen Elektrizitätszähler gemäß dem Oberbegriff des Anspruchs 1 und einen Eingangsbaustein für einen Elektrizitätszähler gemäß dem Oberbegriff der Anspruchs 10.

Aus der CH 687 423 A5 ist ein Elektrizitätszähler, insbesondere ein Multifunktionszähler, bekannt, bei dem für jede Phase jeweils eine Meßeinheit vorgesehen ist. Den jeweiligen Meßeinheiten sind jeweils Strom und Spannung der jeweiligen Phase zugeführt. Jede Meßeinheit erzeugt Ausgangsimpulse, die eine Frequenz besitzen, welche proportional dem in der betreffenden Phase verbrauchten Leistungswert ist. Die Meßeinheiten können gemäß einem Ausführungsbeispiel ausgangsseitig über eine Busstruktur mit einem Mikrocomputer verbunden sein. Die Meßeinheiten weisen als Stromsensor jeweils bevorzugt ein Hallelement auf, dem ein Spannungsfrequenzwandler nachgeschaltet ist. Die Busverbindung ist bevorzugt als normierte bidirektionale Busverbindung ausgebildet, wobei die Meßeinheiten auch digitalisierte Momentanwerte des zugehörigen Phasenlaststromes und der dazugehörigen Phasenspannung liefern können. Die Verarbeitung der aufgenommenen Meßwerte erfolgt dann zunächst in dem nachgeschalteten Mikrocomputer. Gegebenenfalls kann diesem auch eine weitere Verarbeitungseinrichtung mit CPU/Prozessor und zugeordneten Speichern nachgeordnet sein. Zwar findet bei diesen Zählern eine digitale Meßwertverarbeitung statt, es wird jedoch kein konkreter oder separater Analog/Digital-Wandler verwendet.

Aus der US 5,349,676 ist ein digitaler Elektrizitätszähler bekannt, bei dem je zu erfassenden Meßwert (Strom oder Spannung) ein ΣΔ-Modulator als Analog/Digital-Wandler (A/D-Wandler) vorgesehen ist. Die digitalisierten Meßwerte werden dann mittels zweier Prozessoren verarbeitet. Die gesamte Signalverarbeitung inklusive A/D-Wandler, Prozessoren, Speicher usw. sind in einen gemeinsamen IC untergebracht.

Eine ähnliche Anordnung ist aus der US 5,544,089 und aus der US 5,631,843 bekannt. Auch dort sind A/D-Wandler, Filter, Speicher und zumindest ein Prozessor auf einem gemeinsamen Chip untergebracht. Die Lösungen der beiden letztgenannten Veröffentlichungen haben zum Nachteil, daß lediglich spezielle ICs zur Anwendung kommen, die aufgrund ihres hohen Integrationsdichte kostspielig sind und sich nur an spezielle Applikationen orientieren. Weitere digitale Elektrizitätszähler sind aus der DE 195 26 723 C1 und der EP 887 650 bekannt.

Der Erfindung liegt die Aufgabe zugrunde, einen Elektrizitätszähler und einen hierfür geeigneten Eingangsbaustein anzugeben, wobei ausgehend von der Verwendung standardmäßiger Verarbeitungsbausteine und Bauelemente eine optimierte Integration im Hinblick auf die Vorverarbeitung und Erfassung der Eingangssignale vorgesehen sein soll.

Demnach ist ausgehend vom Stand der Technik erfindungsgemäß vorgesehen, daß der Eingangsbaustein als separater, vom Verarbeitungsbaustein getrennter integrierter Schaltkreis ausgebildet ist, und daß als Multipliziermittel ein Hardware-Multiplizierer vorgesehen ist, welcher in den integrierten Schaltkreis integriert ist. Bevorzugt ist der A/D-Wandler als Sigma-Delta-Modulator (ΣΔ-Modulator) ausgeführt, welcher in den integrierten Schaltkreis integriert ist.

Mit dieser einfachen Ausgestaltung ist ein modularer Aufbau eines Elektrizitätszählers gegeben, wobei für die digitale Datenverarbeitung standardmäßig verfügbare Prozessor- oder Rechenbausteine verwendet werden können. Durch den einfachen Aufbau des Eingangsbausteins läßt dieser sich bei hohen Stückzahlen preiswert herstellen, wodurch insgesamt der Elektrizitätszähler mit geringen Kosten und wenig Aufwand herstellbar ist.

Es ist günstig, wenn der Eingangsbaustein Multipliziermittel zum Bilden eines Leistungswerts aufweist. Die Multipliziermittel sind dabei mit Vorteil als Hardware-Multiplizierer ausgeführt sein, welcher in den integrierten Schaltkreis integriert ist. Auf diese Weise ist im nachgeschalteten Bearbeitungsbaustein zeitaufwendiger Rechenaufwand vermieden. Im einfachsten Fall ist lediglich eine Akkumulierung der vom Hardware-Multiplizierer gelieferten Leistungswerte vorzusehen, um zu einem Energieverbrauchswert zu gelangen.

Bevorzugt ist je Phase, insbesondere für drei Phasen, eines Verbrauchers oder des an den Elektrizitätszähler anzuschließenden Netzes ein Eingangsbaustein vorgesehen. Durch die Modularität des Eingangsteils des Elektrizitätszählers ist damit eine einfache Anpassung an die benötigte Phasenzahl gegeben. Es kann auch eine in Gruppen unterteilte Mehrzahl von Eingangsbausteinen vorgesehen sein, wobei jede Gruppe jeweils einem Verbraucher zugeordnet ist. Auf diese Weise ist quasi eine Vielfachmeßanordnung zusammenstellbar, wobei die Energieverbräuche verschiedener Verbraucher mittels einer zentralen Verarbeitungseinrichtung erfaßbar sind.

Es ist günstig, wenn je Eingangsbaustein ein Stromsensor vorgesehen ist, welcher zumindest ein Hallelement umfaßt. Ein derartiger Stromsensor läßt sich auf einfache Weise in den Eingangsbaustein integrieren, wobei der Platzbedarf gering gehalten ist. Alternativ sind selbstverständlich auch andere Arten von Stromsensoren, z.B. ein Feldsensor, eine magnetoresistive Brücke, ein Sensor mit Shunt oder ein herkömmlicher Stromwandler auf magnetischer Basis einsetzbar.

Bevorzugt ist die Verbindung zwischen Eingangsbaustein oder Bausteinen und dem Verarbeitungsbaustein als Busverbindung ausgebildet, wobei jeder Eingangsbaustein hierzu einen Buskoppler oder Schnittstellenbaustein aufweist. Auf diese Weise ist eine schnelle Datenübergabe von dem/den Eingangsbaustein/en zum Verarbeitungsbaustein möglich, was einen hohen Datendurchsatz bei hoher Auflösung ermöglicht. Die Datenübergabe kann dabei parallel oder seriell erfolgen.

Mit Vorteil kann für den analogen Strom- und den analogen Spannungseingang je ein A/D-Wandler vorgesehen sein. Auf diese Weise ist eine getrennte Signalverarbeitung gegeben, bei der eine gegenseitige Beeinflussung gering gehalten ist.

Es ist günstig, wenn jeder Eingangsbaustein einen Speicher umfaßt, in welchem Parameter und/oder Betriebseinstellungen und/oder sonstige für den Betrieb vorgeb- oder einstellbare Daten gespeichert oder speicherbar sind. Damit ist ein Minimum an Betriebsinformationen im Verarbeitungsbaustein hinterlegbar. Dazu können für jeden Verarbeitungsbaustein getrennt Parameter hinterlegt sein, die beispielsweise bereits während der Herstellung hinterlegt werden und auf die während des Betriebs im eingebauten Zustand zurückgegriffen werden kann. Dies betrifft z.B. Voreinstellungen oder Abgleichinformationen. Eine Belastung der Speicherressourcen des Verarbeitungsbausteins ist damit nicht erforderlich.

Die Lösung der Aufgabe bezüglich des Eingangsbaustein gelingt erfindungsgemäß mit den Merkmalen des Anspruchs 10. Die oben angegebenen Vorteile gelten hier sinngemäß. Derartige Eingangsbausteine eignen sich insbesondere zum Einsatz bei Haushaltszählern oder Drehstromzählern in einphasiger oder dreiphasiger Ausführung.

Ausführungsbeispiele der Erfindung, weitere Vorteile und Details werden nachfolgend anhand der Zeichnung näher erläutert. Es zeigen:

FIG 1    ein Blockschaltbild für alternative Ausführungen eines Elektrizitätszählers mit einem oder mehreren Eingangsbaustein/en,

FIG 2    ein Blockschaltbild zur Beschaltung eines Eingangsbausteins gemäß FIG 1,

FIG 3    ein Blockschaltbild zum Innenaufbau eines Eingangsbausteins,

FIG 4    eine alternative Ausführungsform zum Innenaufbau eines Eingangsbausteins,

FIG 5    ein Blockschaltbild zur Signalverarbeitung und zum Datenfluß des Elektrizitätszählers, und

FIG 6    eine alternative Ausführungsform zur FIG 5.

In den nachfolgenden Figuren sind gleiche Bauteile mit gleichen oder zumindest sinngemäß gleichen Bezugszeichen versehen.

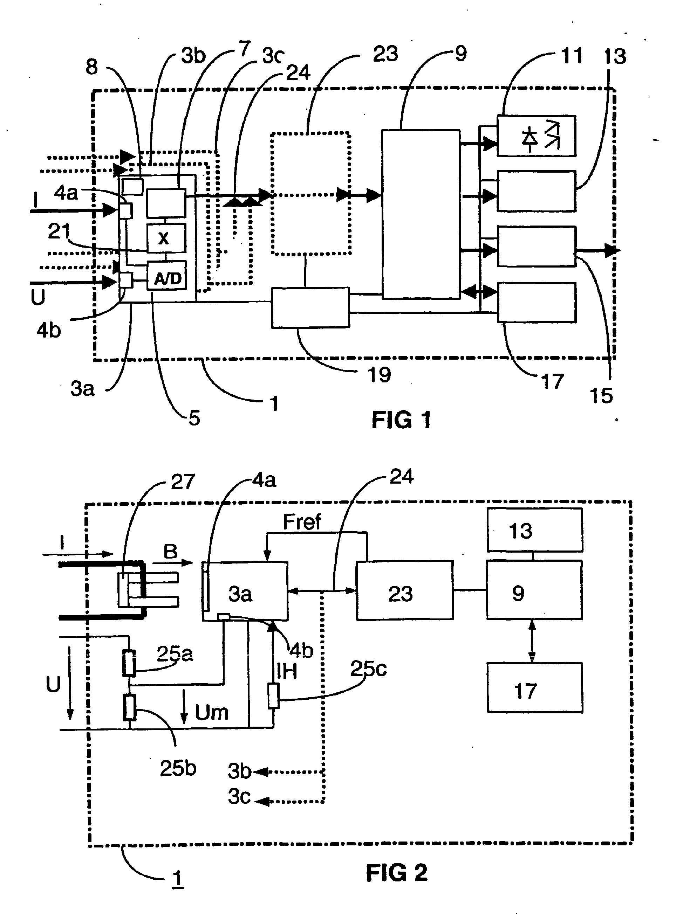

FIG 1 zeigt ein Blockschaltbild eines Elektrizitätszählers 1 (nachfolgend Zähler 1 genannt). Der Zähler 1 weist einen Eingangsbaustein 3a auf, dem ein analoges Stromsignal I und ein analoges Spannungssignal U (nachfolgend als Signale I bzw. U bezeichnet) eines nicht näher gezeigten Verbrauchers zugeführt sind. Ziel ist es dabei, den Energieverbrauch des Verbrauchers zu erfassen.

Der Eingangsbaustein 3a weist dazu einen analogen Strom- und einen analogen Spannungseingang 4a bzw. 4b auf. Über diese Eingänge sind die beiden Signale I und U einem als A/D-Wandler ausgebildeten Signalwandlermittel 5 zugeführt, der aus den analogen Signalen digitale Werte erzeugt. Die digitalen Werte von Strom und Spannung I bzw. U werden dann über einen Ausgangsbaustein 7 an einen nachgeschalteten Verarbeitungsbaustein 9 weitergeführt.

Der Verarbeitungsbaustein 9 ist als digitaler Baustein ausgeführt und kann beispielsweise von einem Mikrocomputer, einem Rechner oder einem sonstigen handelsüblichen Prozessor gebildet sein. In dem Verarbeitungsbaustein 9 erfolgt die datentechnische Verarbeitung der erfaßten Signale zur Bildung der gewünschten Energieverbrauchswerte. Dies können beliebige nach dem Stand der Technik gebildete Werte sein, die allgemein von Zählern gebildet werden können, z.B. Wirkleistung, Blindleistung, Maximumwerte, Oberwellenleistung, Energieverbrauch usw.. Eine Beschränkung auf bestimmte Verbrauchswerte ist dabei nicht gegeben. Die Verarbeitung der Daten im Verarbeitungsbaustein 9 erfolgt mit Hilfe eines oder mehrerer gespeicherter Programme.

Die ermittelten Energieverbrauchswerte oder Informationen werden dann von dem Verarbeitungsbaustein 9 über beliebige Ausgabemodule oder Kommunikationsbausteine ausgegeben. Dies können beispielsweise sein: ein Impulsausgangsbaustein 11 nach Art einer Blinkanzeige (z.B. mit Leuchtdiode gemäß FIG 1), wobei die jeweiligen Blinkimpulse einen vorgegebenen Energiewert repräsentieren, ein Display 13 zur Anzeige der verschiedenen Werte, und/oder ein Kommunikationsmodul 15, über das nach Art einer Schnittstelle Daten an weitere Verarbeitungseinrichtungen weitergegeben werden kann. Selbstverständlich kann auch ein nicht näher gezeigtes Eingabemittel, z.B. eine Tastatur oder ein Bedienfeld, vorgesehen sein, welches z.B. in einer Baueinheit mit dem Display 13 ausgeführt sein kann.

Gegebenenfalls kann dem Verarbeitungsbaustein 9 -falls nicht indirekt zugeordnet oder integriert- auch ein Speichermodul 17 zugeordnet sein, in welchem das oder die Programm/e zur Datenverarbeitung und zum Betrieb oder sonstige Informationen für den Betrieb des Zählers 1 hinterlegt sein können. Das Speichermodul 17 kann dabei insbesondere einen nichtverlierbaren Speicher, z.B. ein ROM oder EEPROM, zur dauerhaften Speicherung von Daten umfassen. Zum allgemeinen Betrieb des Zählers 1 weist dieser selbstverständlich als Energieversorgung ein Netzteil 19 auf, das die jeweiligen Hardwarebausteine über nicht näher bezeichnete Leitungen mit elektrischer Energie versorgt.

Diese erläuterte Ausführung des Zählers 1 dient beispielhaft für einen sogenannten Einphasenzähler. Ausgehend von einem modularen Aufbau des Eingangsbausteins 3a, bei dem der Ausgangsbaustein 7 als Buskoppler oder Interface ausgebildet ist, ist auch eine Kaskadierung oder Vervielfachung von Eingangsbausteinen möglich. In der Figur sind dazu weitere optionale Eingangsbausteine 3b und 3c stichliert dargestellt, die mit dem Eingangsbaustein 3a über ihre jeweiligen nicht näher dargestellten Ausgangsbausteine und eine Busverbindung 24 parallel geschaltet sind. Auf diese Weise sind mehrphasige Ausführungen des Zählers 1 realisierbar. Selbstverständlich sind für eine derartige Anordnung die Phasenspannungen und - ströme der übrigen Phasen bevorzugt phasenbezogen den jeweiligen Eingangsbausteinen 3b bzw. 3c, zuzuführen. Die Eingangsbausteine 3a bis 3c können dabei auch als sogenannte "Front-End-Bausteine" bezeichnet werden.

Gegebenenfalls sind auch mehrere Gruppen von Eingangsbausteinen derart zusammenschaltbar, daß Energieverbräuche verschiedener Verbraucher mit einem gemeinsamen Zähler 1, insbesondere einem gemeinsamen Verarbeitungsbaustein 9 erfaßt werden können. Damit ist ein einfacher modularer Aufbau mit geringem technischen Aufwand für eine vielfach Energieerfassung realisierbar. Mit dem gezeigten Zähler 1 gemäß FIG 1 könnten beispielsweise die Energieverbräuche dreier (oder mit mehreren Eingangsbausteinen auch noch mehrerer) einphasiger Verbraucher erfaßt werden. Ggf. können mit einem derartigen Eingangsbaustein auch sonstige Signale, z.B. eine Temperatur oder ein Impulssignal, erfaßt werden.

Der Eingangsbaustein 3a umfasst bevorzugt auch ein Multipliziermittel zum Bilden eines Leistungswertes W. Bevorzugt ist das Multipliziermittel 21 ein Hardware-Multiplizierer oder ein Multiplizierbaustein. Damit ist je Eingangsbaustein 3a, 3b, 3c ein Leistungswert erzeugbar, der zusammen mit Strom- und Spannungsdaten an den Verarbeitungsbaustein 9 übergeben werden kann. Damit ist im Verarbeitungsbaustein 9 der Rechenaufwand erheblich verringert, wodurch andere Funktionen oder bisherige Funktionen schneller erledigt werden können.

Wesentlich für den Aufbau des gezeigten Zählers 1 ist, daß der gesamte Eingangsbaustein 3a (bzw. 3b oder 3c) als separater, vom Verarbeitungsbaustein 9 getrennter integrierter Schaltkreis ausgebildet ist. Damit ist also eine quasi dezentrale modulare Aufbauweise gegeben, die einen einfachen Aufbau verschiedenster Zählervarianten mit prinzipiell gleichen oder standardmäßigen Bausteinen erlaubt. Durch den Einsatz des gleichen integrierten Eingangsbausteins für ein- und mehrphasige Zähler sind hohe Stückzahlen erzielbar, wodurch der Eingangsbaustein 3a in seiner Herstellung günstig wird.

Der Eingangsbaustein 3a kann gegebenenfalls auch einen Speicher 8 umfassen, in welchem Parameter und/oder Betriebseinstellungen und/oder sonstige für den Betrieb erforderliche Daten, z.B. Einstellwerte, Kalibrierwerte oder Konstanten, abgelegt sind.

Zusätzlich kann zwischen Eingangsbaustein 3a und Verarbeitungsbaustein 9 auch ein weiterer Verarbeitungsbaustein 23 geschaltet sein, welcher beispielsweise als digitaler Signalprozessor ausgebildet sein kann. Damit ist eine einfache Datenvorverarbeitung möglich, wodurch eine optimale Aufgabenverteilung innerhalb des Zählers 1 im Hinblick auf ein langsames oder schnelles Signalprocessing vorgesehen werden kann.

Ein derartiger Aufbau kann auch als Zwei-Prozessor-Lösung bezeichnet werden. Auf den Aufbau des Eingangsbausteins 3a wird bei den weiteren Figuren noch näher eingegangen.

FIG 2 zeigt einen Zähler 1 in einer Blockschaltbilddarstellung, bei dem der Eingangsbereich, insbesondere die äußere Beschaltung des Eingangsbausteins 3a, näher erläutert ist. Der Zähler 1 weist zur Erfassung von Strom I und Spannung U einen Stromsensor bzw. einen Spannungssensor auf. Der Spannungssensor ist vorliegend von einem Spannungsteiler gebildet, der zwei Widerstände 25a und 25b umfaßt. Die am Verbraucher abgegriffene Spannung U wird mit dem Spannungsteiler geteilt und als Meßspannung Um dem Eingangsbaustein 3a zugeführt. Die Widerstände 25a und 25b sind bevorzugt nicht Bestandteil des Eingangsbausteins 3a und gehören zu seiner externen Beschaltung. Sie können jedoch mit dem Eingangsbaustein 3a auf einer gemeinsamen Platine oder gedruckten Schaltung angeordnet sein. Damit ist der Eingangsbaustein 3a für verschiedenste Fälle mit unterschiedlicher Spannung anwendbar. Eine Anpassung erfolgt dann im jeweiligen Anwendungsfall durch eine geeignete Auswahl dieser Beschaltung.

Das Stromsignal I des Verbrauchers wird über einen Kern 27 als magnetisches Feld B dem Eingangsbaustein 3a zugeführt und dort mittels einer Wandlung in ein elektrisches Meßsignal überführt. Der Stromeingang 4a ist hier also als Feldeingang ausgebildet. Bevorzugt wird zur Stromerfassung ein hier nicht näher gezeigtes Hallelement verwendet, das ebenfalls in den Eingangsbaustein 3a integriert sein kann. Damit kann der Eingangsbaustein 3a bei entsprechender Dimensionierung auf einfache Weise direkt in einen Luftspalt des Kerns 27 eingefügt werden. Selbstverständlich ist alternativ auch eine kernlose Ausführung möglich.

Für die Funktion des Eingangsbausteins 3a kann es erforderlich sein, daß diesem von dem weiteren Verarbeitungsbaustein 23 oder einer sonstigen Einrichtung innerhalb des Zählers 1 ein Taktsignal Fref zugeführt ist. Mit dem Bezugszeichen 25c ist ein weiterer Widerstand oder Referenzwiderstand bezeichnet, der zur Erzeugung eines Bezugsstromes für den Eingangsbaustein 3a, insbesondere als Feldstrom IH für sein Hallelement, dient. Der Feldstrom IH wird dabei durch Anlegen des Referenzwiderstands 25c an eine Referenzspannung erzeugt, die innerhalb des Eingangsbausteins 3a zur Verfügung steht.

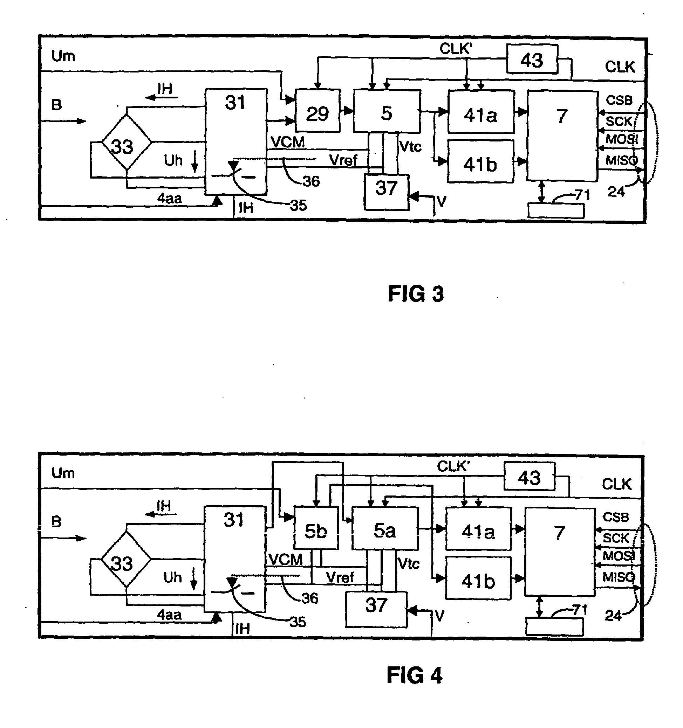

FIG 3 zeigt einen näheren Aufbau eines Eingangsbausteins 3a, bei dem als Signalwandlermittel 5 ein gemeinsamer A/D-Wandler für Strom I und Spannung U verwendet wird. Dem A/D-Wandler 5 ist dazu ein Multiplexer 29 vorgeschaltet. Auf einen Eingang des Multiplexers 29 ist die Meßspannung Um geführt. Als Stromsensor dient vorliegend ein Hallelement 33, das das (vom Strom I erzeugte) Feld B erfaßt. Dem Hallelement 33 ist eine analoge Hilfsschaltung 31 zugeordnet. Hallelement 33 und analoge Hilfsschaltung 31 bilden quasi den Eingangsbereich der Stromerfassung. Dem Hallelement 33 wird von der Hilfsschaltung 31 der Referenz-, Bezugs- oder Feldstrom IH zugeführt. Das eigentliche Meßsignal Uh, das eine stromproportionale Spannung ist, wird dann der Hilfsschaltung 31 zugeführt, die es dann für die weitere Verarbeitung verstärkt. Näheren Ausbildungen der Hilfsschaltung 31 mit dem Hallelement 33 ergeben sich nach dem allgemeinen bekannten Stand der Technik, z.B. nach der DE 37 02 344 A1 oder der DE 37 11 978 C2. Das Hallelement 33 kann dabei wahlweise als vertikales oder horizontales Hallelement ausgebildet sein.

Zusätzlich oder alternativ kann auch eine Stromerfassung mittels einem herkömmlichen Stromsensors, z.B. nach Art eines magnetischen Stromwandlers oder mit Shunt, vorgesehen sein. Dazu weist die Hilfsschaltung 31 einen Stromeingang 4aa auf, dem direkt ein Strom I zugeführt werden kann. Bei universeller Ausgestaltung der Hilfsschaltung 31 kann diese beispielsweise steuerbare Umschaltmittel 35 umfassen, über die die jeweils gewünschte Stromerfassungsart über einen Signaleingang oder per Software eingeschaltet oder vorgegeben werden kann.

Weiterhin umfaßt der Eingangsbaustein 3a eine Referenzspannungsquelle 37. Die Referenzspannungsquelle 37 liefert zwei Referenzspannungen: eine temperaturstabile Spannung Vref und eine temperaturabhängige Spannung Vtc. Der Temperaturgang der Spannung Vtc entspricht dem des Hallelements 33. Die Spannung Vtc wird als Referenzspannung für den A/D-Wandler 5 verwendet, wodurch die Temperaturabhängigkeit des Hallelements 33 oder dessen Temperaturgang kompensiert ist. Weiterhin liefert die Referenzspannungsquelle 37 noch eine Bezugsspannung VCM, die bei Bedarf den jeweiligen Modulen zugeführt werden kann. Die Referenzspannungsquelle 37 kann auch Teilspannungsquellen oder Module zur Erzeugung der jeweiligen Spannungen umfassen. Selbstverständlich wird der Eingangsbaustein 3a und die Referenzspannungsquelle 37 von dem Netz mit einer Spannung V versorgt.

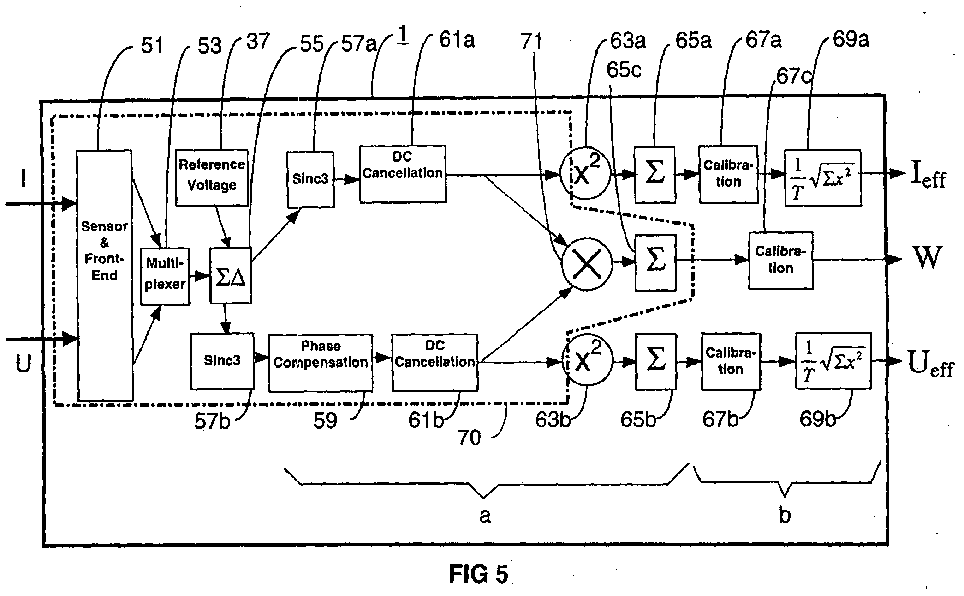

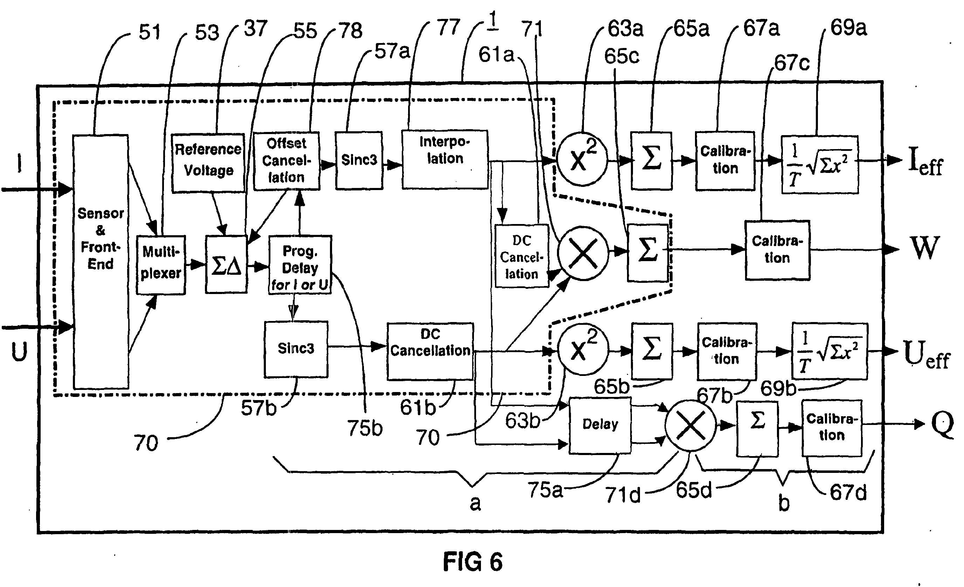

Der A/D-Wandler 5 ist vorliegend als $\Sigma\Delta$-Modulator (Sigma-Delta-Modulator) ausgeführt. Dieser erzeugt ausgangsseitig als digitales Signal einen Bitstrom. Um diesen Bitstrom in Bitworte umzuwandeln, sind dem A/D-Wandler 5 Decimationsfilter 41a und 41b nachgeschaltet. Diese wandeln die serielle Information in parallele digitale Signale um. Die erzeugten Bitworte werden dann über den Ausgangsbaustein 7, der beispielsweise als sogenanntes Interface oder Buskoppler ausgebildet ist, an den nachgeschalteten (in dieser Figur nicht gezeigten) Verarbeitungsbaustein 9 über die Busverbindung 24 weitergegeben. Über diesen Ausgangsbaustein 7 werden zudem die Bitworte aus den Decimationsfiltern 41a,41b zwecks Leistungswertbildung einem Multipliziermittel 71 zugeführt, das vorteilhafterweise als Hardware-Multiplizierer ausgebildet ist. Für die funktionale Beschreibung der Leistungswertbildung wird auf die FIG 5 und die FIG 6 und deren Beschreibung weiter unten verwiesen.

Der Ausgangsbaustein 7 tauscht folgende Signale mit dem Verarbeitungsbaustein 9 im Betrieb aus:

Signal CSB (Chip-Select/Chip-Auswahl)

Dieses Signal CSB wird dem Eingangsbaustein 3a über eine separate Leitung zugeführt und dient zur Auswahl oder zur Aktivierung des jeweiligen Eingangsbausteins, mit dem kommuniziert werden soll. Dies ist insbesondere bei Anwendungen mit mehreren Eingangsbausteinen wichtig.

Signal SCK (Shift-Clock/ Taktsignal)

Das Signal SCK gibt den Takt für die Informationsübertragung zwischen Eingangsbaustein 3a und dem Verarbeitungsbaustein 9 vor.

Signal MOSI (Master Out, Slave In)

Mit dem Signal MOSI werden Informationen, insbesondere Befehle, vom "Master", also z.B. vom Verarbeitungsbaustein 9, an den "Slave", also dem Eingangsbaustein 3a, übertragen.

Signal MISO (Master In, Slave Out)

Das Signal MISO gilt analog zum Signal MOSI für die entgegengesetzte Informationsrichtung, also vom Eingangsbaustein 3a zum Verarbeitungsbaustein 9 und dient im wesentlichen zur Datenausgabe.

Je nach Ausführung der Funktion des A/D-Wandlers 5 kann diesem auch ein optionales Decimationsfilter 41b nachgeschaltet sein, so daß eine getrennte Aufbereitung der Signale für Strom und Spannung möglich ist. Auf diese Weise kann gegebenenfalls die Signalverarbeitung erheblich beschleunigt werden.

Dem Eingangsbaustein 3a wird, wie bereits oben beschrieben, über eine Leitung ein Taktsignal CLK zugeführt. Das Taktsignal CLK wird gegebenenfalls über einen Teilerbaustein 43 geführt, wodurch eine niedrigere Taktfrequenz CLK' erzeugt ist. Die Taktsignale CLK oder CLK' werden dann den jeweiligen Bausteinen oder Modulen entsprechend der jeweils vorgesehenen Verarbeitungsgeschwindigkeit für deren Funktion zugeführt. Dies betrifft insbesondere den Multiplexer 29, den A/D-Wandler 5 und die Decimationsfilter 41a und 41b.

FIG 4 zeigt einen alternativen Aufbau, bei dem auf den Multiplexer 29 verzichtet ist. Dazu ist für Strom und Spannung jeweils ein getrennter A/D-Wandler 5a bzw. 5b vorgesehen. Jedem A/D-Wandler 5a, 5b ist dabei ein jeweiliges Decimationsfilter 41a bzw. 41b zugeordnet. Der übrige Aufbau entspricht FIG 3 sinngemäß. Eventuell sind geringfügige Anpassungen zur besseren oder schnelleren Signalverarbeitung im Rahmen üblicher Anpassungsmaßnahmen erforderlich.

FIG 5 zeigt in Ergänzung der bereits oben beschriebenen Figuren ein Diagramm für den Signalfluß innerhalb des Zählers 1 für eine einphasige Signalverarbeitung. Das Strom- und Spannungssignal I bzw. U werden zunächst von Sensormittel 51 (Sensor & Front-End) erfaßt und über den Multiplexer 53 einer Analog-Digital-Wandlung 55 (ΣΔ) zugeführt. Der Analog-Digital-Wandlung 55 wird von der Referenzspannungsquelle 37 (Reference Voltage) eine Referenzspannung zugeführt. Anschließend werden -getrennt für Strom I und Spannung U- die entsprechenden Daten der Filterbearbeitung in den Decimationsfiltern 57a bzw. 57b (Sinc3) unterworfen. Dabei werden aus einem Bitstrom Bitworte für die jeweiligen Daten gebildet.

Bezogen auf die Spannung U kann gegebenenfalls eine Phasenkorrektur 59 (Phase Compensation) vorgesehen werden. Damit ist ein insbesondere durch den Multiplexer 53 bedingter Phasenunterschied zwischen Strom und Spannung eliminierbar. Die Bearbeitungsbausteine 61a und 61b dienen zur Gleichanteilunterdrückung (DC-Cancellation) und sind verarbeitungstechnisch als Hochpaß realisiert. Es schließen sich dann noch je Verarbeitungszweig (Spannung oder Strom) für die jeweiligen Datensätze Bearbeitungsschritte für eine Quadratbildung 63a, 63b (X²), eine Akkumulierung oder Summenbildung 65a, 65b (Σ) und Kalibrierschritte 67a, 67b (Calibration) an. Mit den Verarbeitungsmodulen 69a, 69b erfolgt dann jeweils die Berechnung der effektiven Werte Ieff bzw. Ueff für Strom und Spannung entsprechend der Formel:

$$\frac{1}{T}\sqrt{\Sigma x^2}\ .$$

Wie bereits oben beschrieben, kann der Eingangsbaustein 3a auch zusätzlich Multipliziermittel aufweisen, die vorliegend von einem Multipliziermodul 71 realisiert sind. Durch diesen Multiplizierschritt sind Leistungswerte gebildet. Zur Erzeugung eines Energiewertes W schließt sich eine Akkumulierung oder ein Summierglied 65c (Σ) und gegebenenfalls ein Kalibrierglied 67c (Calibration) an.

Mit der strichpunktierten Linie 70 sind die Elemente, Module oder Bearbeitungsschritte umfaßt, die bevorzugt innerhalb des Eingangsbausteins 3a realisiert sind. Die von der Klammer a umfaßten Bearbeitungsschritte unterliegen dabei einer schnellen Signalverarbeitung. Unter schnell wird dabei eine Verarbeitung im kHz-Bereich, z.B. zwischen 1 und 10 kHz, insbesondere etwa 2 kHz, verstanden. Die Klammer b umfaßt die Schritte, die eine relativ langsame Datenverarbeitung umfassen, welche im Frequenzbereich von etwa 1 bis 10 Hz, insbesondere 1 bis 4 Hz liegen kann.

FIG 6 zeigt ein Flußdiagramm (im wesentlichen dem von FIG 5 entsprechend), bei dem Bearbeitungsschritte zur Erzeugung eines Blindleistungswerts Q vorgesehen sind. Die Bearbeitungsschritte hierzu sind im Prinzip analog zu den bei der Erzeugung des Energiewertes W in FIG 5 zu verstehen. Dazu ist zunächst ein Verzögerungsglied 75a (Delay) vorgesehen, mit welchen die Werte Strom I und Spannung U verzögert werden(um den erforderlichen Phasenversatz für die Blindleistung zu erhalten). Es folgt dann ein Multipliziermodul 71, ein Akkumulier- oder Summierglied 65d (Σ) mit anschließender Kalibrierung 67d (Calibration).

Im Unterschied zu FIG 5 sind auch vereinzelt Verarbeitungsschritte unterschiedlich aufgeteilt oder optionale Schritte vorgesehen. Eine Phasenkompensation im Spannungspfad ist hier nicht vorgesehen. Zusätzlich ist jedoch z.B. eine Verzögerungseinrichtung 75b vorgesehen, mit welcher ein Winkelfehler im Sensormittel 51 kompensierbar ist. Weiterhin sind ein Interpolierglied 77 (Interpolation) und eine Offsetunterdrückung 78 (Offset Cancellation) vorgesehen. Die Offsetunterdrückung 78 ermöglicht es, Gleich- oder DC-Anteile im Strom I richtig zu erfassen und bei der Berechnung des Effektivwertes (Ieff) zu berücksichtigen.

Wesentliche der in den Figuren 5 und 6 dargestellten Bearbeitungsbausteine, Module oder Verarbeitungsschritte nach der A/D-Wandlung sind dabei als Softwarebausteine oder Programmschritte im Rahmen der digitalen Signalverarbeitung zu verstehen. Wesentlich für die vorliegende neue Idee ist, daß ein kleiner, hoch integrierter Eingangsbaustein vorgesehen ist, der universell für verschiedenste Anwendungen eingesetzt werden kann. Damit kann für die nachfolgende Signalverarbeitung auf standardmäßige Prozessoren oder digitale Signalprozessoren zurückgegriffen werden. Der Aufbau eines derartigen Zählers 1 wird dadurch besonders einfach und kostensparend. Als Spezialbaustein für den Zähler 1 ist dabei lediglich der Eingangsbaustein 1 erforderlich, der durch seine modulare Verwendungsweise vielfache Anwendungsmöglichkeiten offen läßt. Durch Kombination mit herkömmlichen Verarbeitungsbausteinen ist ein besonders zuverlässiger kostengünstiger Zähler realisierbar.

Der Eingangsbaustein kann dabei als kleiner IC ausgeführt sein, der beispielsweise als SMD-Bauteil auf einer Platine des Zählers 1 montiert oder gelötet werden kann. Für Spezialanwendungen ist es auch denkbar, daß lediglich nur Teilfunktionen (z.B. die Erzeugung von Ieff und Ueff) des Eingangsbausteins in einem Zähler genutzt werden, da der Eingangsbaustein durch seine preiswerte Herstellung bei hohen Stückzahlen sehr attraktiv ist. Die übrigen Funktionen werden dann auf zusätzliche Bausteine ausgelagert.

**Patentansprüche**

1.  Eingangsbaustein (3a,3b,3c) für einen Elektrizitätszähler (1) mit:

    - einem analogen Strom- und einem analogen Spannungseingang (4a,4aa bzw. 4b), wobei diese Eingänge mit einem einen Σ/Δ-Modulator (5,5a,5b,55) umfassenden Signalwandlermittel (5,5a,5b,55,41a,41b) verbunden sind, und
    - Hardware-Multipliziermittel (21,71) zum Bilden eines Leistungswertes (W),

- wobei als Signalwandlermittel (5,5a,5b, 55,41a,41b) zumindest ein Analog/Digital-Wandler vorgesehen ist, der den $\Sigma/\Delta$-Modulator (5,5a,5b,55) und mindestens einen Dezimationsfilter (41a,41b) umfasst

- und wobei das Hardware-Multipliziermittel (21,71) in den integrierten Schaltkreis integriert und dem Analog/Digital-Wandler (5, 5a, 5b, 55, 41a, 41b) nachgeschaltet ist,

**dadurch gekennzeichnet, daß**

- der Eingangsbaustein (3a, 3b, 3c) als einphasiger integrierter Schaltkreis ausgebildet ist.

**2.** Elektrizitätszähler (1) mit zumindest einem Eingangsbaustein (3a,3b,3c) nach Anspruch 1.

**3.** Elektrizitätszähler nach Anspruch 2, wobei je Phase eines zugeordneten Verbrauchers jeweils ein Eingangsbaustein (3a,3b,3c) vorgesehen ist.

**4.** Elektrizitätszähler nach einem der Ansprüche 2 oder 3, wobei eine in Gruppen unterteilte Mehrzahl von Eingangsbausteinen (3a,3b,3c) vorgesehen ist, und wobei jede Gruppe jeweils einem Verbraucher zugeordnet sind.

**5.** Elektrizitätszähler nach einem der Ansprüche 2 bis 4, wobei je Eingangsbaustein (3a,3b,3c) ein Stromsensor (51) vorgesehen ist, welcher zumindest ein Hallelement (33) umfasst.

**6.** Elektrizitätszähler nach einem der Ansprüche 2 bis 5, wobei die Verbindung zwischen Eingangsbaustein/en (3a,3b,3c) und einem Verarbeitungsbaustein (9) als Busverbindung (24) ausgebildet ist und jeder Eingangsbaustein (3a,3b,3c) einen Buskoppler aufweist.

**7.** Elektrizitätszähler nach einem der Ansprüche 2 bis 6, wobei für den analogen Strom- und den analogen Spannungseingang (4a bzw. 4b) je ein Analog/Digital-Wandler (5a bzw. 5b) vorgesehen ist.

**8.** Elektrizitätszähler nach einem der Ansprüche 2 bis 6, wobei für den analogen Strom- und den analogen Spannungseingang (4a, 4aa bzw. 4b) ein gemeinsamer Analog/Digital-Wandler (5,55) vorgesehen ist, dem ein Multiplexer (29,53) vorgeschaltet ist.

**9.** Elektrizitätszähler nach einem der Ansprüche 2 bis 8, wobei jeder Eingangsbaustein (3a,3b,3c) einen Speicher umfasst in welchem Parameter und/oder Betriebseinstellungen und/oder sonstige für den Betrieb vorgeb- oder einstellbare Daten speicherbar sind.

**Claims**

**1.** An input module (3a, 3b, 3c) for an electricity meter (1) comprising:

- an analog current and an analog voltage input (4a, 4aa or 4b), wherein these inputs are connected to signal converter means (5, 5a, 5b, 55, 41a, 41b) comprising an $\Sigma/\Delta$ modulator (5, 5a, 5b, 55) and
- hardware multiplying means (21, 71) for forming a power value (W),
- wherein at least one analog/digital converter is provided as signal converter means (5, 5a, 5b, 55, 41a, 41b), which comprises the $\Sigma/\Delta$ modulator (5, 5a, 5b, 55) and at least one decimation filter (41a, 41b)
- and wherein the hardware multiplying means (21, 71) is integrated in the integrated circuit and is connected after the analog/digital converter (5, 5a, 5b, 55, 41a, 41b),

**characterised in that**

- the input module (3a, 3b, 3c) is constructed as a single-phase integrated circuit.

**2.** Electricity meter (1) comprising at least one input module (3a, 3b, 3c) according to claim 1.

**3.** The electricity meter according to claim 2, wherein respectively one input module (3a, 3b, 3c) is provided for each phase of an allocated load.

**4.** The electricity meter according to any one of claims 2 or 3, wherein a plurality of input modules (3a, 3b, 3c) subdivided into groups is provided and wherein each group is allocated to respectively one load.

**5.** The electricity meter according to any one of claims 2 to 4, wherein a current sensor (51) comprising at least one Hall element (33) is provided per input module (3a, 3b, 3c).

**6.** The electricity meter according to any one of claims 2 to 4, wherein the connection between input module (s) (3a, 3b, 3c) and a processing module (9) is constructed as a bus connection (24) and each input module (3a, 3b, 3c) has a bus coupler.

**7.** The electricity meter according to any one of claims 2 to 6, wherein respectively one analog/digital converter (5a or 5b) is provided for the current and the analog voltage input (4a or 4b) .

**8.** The electricity meter according to any one of claims 2 to 6, wherein a common analog/digital converter (5, 55) with a multiplexer (29, 53) connected ahead thereof is provided for the analog current and the analog voltage input (4a, 4aa or 4b) .

9. The electricity meter according to any one of claims 2 to 8, wherein each input module (3a, 3b, 3c) comprises a memory in which parameters and/or operating settings and/or other data which can be predefined or set for operation are stored.

**Revendications**

1. Composante d'entrée (3a, 3b, 3c) pour compteur d'électricité (1), comportant :

- une entrée de courant analogigue et une entrée de tension analogique (4a, 4aa ou 4b), ces entrées étant reliées à un moyen de conversion de signaux (5, 5a, 5b, 55, 41a, 41b) englobant un modulateur Σ/Δ (5, 5a, 5b, 55) et
- des moyens matériels de multiplication (21, 71) pour établir une valeur de puissance (W),
- étant prévu comme moyens de conversion de signaux (5, 5a, 5b, 55, 41a, 41b) un convertisseur analogique/numérique qui inclut le modulateur Σ/Δ (5, 5a, 5b, 55) et au moins un filtre de décimation (41a, 41b)
- et le moyen matériel de multiplication (21, 71) étant intégré dans le circuit intégré et branché en aval du convertisseur analogique/numérique (5, 5a, 5b, 55, 41a, 41b),

**caractérisée en ce que**

- la composante d'entrée (3a, 3b, 3c) est réalisée sous forme d'un circuit intégré monophasé.

2. Compteur d'électricité (1) comportant au moins une composante d'entrée (3a, 3b, 3c) selon la revendication 1.

3. Compteur d'électricité selon la revendication 2, dans lequel il est prévu par phase d'un consommateur associé respectivement une composante d'entrée (3a, 3b, 3c).

4. Compteur d'électricité selon une des revendications 2 ou 3, dans lequel il est prévu une pluralité de composantes d'entrée (3a, 3b, 3c) subdivisées en groupes et dans lequel chaque groupe est associé respectivement à un consommateur.

5. Compteur d'électricité selon une des revendications 2 à 4, dans lequel il est prévu par composante d'entrée (3a, 3b, 3c) un capteur de courant (51) qui inclut au moins un élément Hall (33).

6. Compteur d'électricité selon une des revendications 2 à 5, dans lequel la connexion entre la(les) composante(s) d'entrée (3a, 3b, 3c) et une composante de traitement (9) est réalisée sous forme d'une connexion bus (24) et chaque composante d'entrée (3a, 3b, 3c) présente un coupleur bus.

7. Compteur d'électricité selon une des revendications 2 à 6, dans lequel, pour l'entrée de courant analogique et l'entrée de tension analogique (4a ou 4b), il est prévu à chaque fois un convertisseur analogique/numérique (5a ou 5b).

8. Compteur d'électricité selon une des revendications 2 à 6, dans lequel, pour l'entrée de courant analogique et l'entrée de tension analogique (4a, 4aa ou 4b), il est prévu un convertisseur analogique/numérique commun (5, 55) en amont duquel est branché un multiplexeur (29, 53).

9. Compteur d'électricité selon une des revendications 2 à 8, dans lequel chaque composante d'entrée (3a, 3b, 3c) inclut une mémoire dans laquelle peuvent être sauvegardés des paramètres et/ou des réglages de fonctionnement et/ou d'autres données prescriptibles ou réglables pour le fonctionnement.

**FIG 1**

**FIG 2**

**FIG 3**

**FIG 4**

FIG 5

EP 1 114 326 B1

**FIG 6**

EP 1 114 326 B1